(19) **Europäisches Patentamt / European Patent Office / Office européen des brevets**

(11) **EP 1 284 425 B1**

(12) # EUROPÄISCHE PATENTSCHRIFT

(45) Veröffentlichungstag und Bekanntmachung des Hinweises auf die Patenterteilung:
**30.05.2007 Patentblatt 2007/22**

(51) Int Cl.:
*G01R 15/24* (2006.01)    *G01R 1/07* (2006.01)
*G01R 29/08* (2006.01)    *G02F 1/03* (2006.01)
*G02F 1/061* (2006.01)    *G02F 1/065* (2006.01)

(21) Anmeldenummer: **02017487.6**

(22) Anmeldetag: **05.08.2002**

(54) **Verfahren und Vorrichtung zur Störgrössenkompensation eines optischen Sensors**

Procedure and device for interference compensation of an optical sensor

Procédé et appareil de compensation des parasites d'un capteur optique

(84) Benannte Vertragsstaaten:
**DE FR GB IT**

(30) Priorität: **17.08.2001 DE 10140482**

(43) Veröffentlichungstag der Anmeldung:
**19.02.2003 Patentblatt 2003/08**

(73) Patentinhaber: **SIEMENS AKTIENGESELLSCHAFT**
**80333 München (DE)**

(72) Erfinder: **Kraemmer, Peter**
**91052 Erlangen (DE)**

(56) Entgegenhaltungen:
EP-A- 0 390 581       WO-A-95/10046
WO-A-96/12195       GB-A- 1 353 543
US-A- 4 002 975       US-A- 4 269 483
US-A- 5 764 046       US-A- 6 016 702

• MITSUI T ET AL: "DEVELOPMENT OF FIBER-OPTIC VOLTAGE SENSORS AND MAGNETIC-FIELD SENSORS" IEEE TRANSACTIONS ON POWER DELIVERY, IEEE INC. NEW YORK, US, Bd. PWRD-2, Nr. 1, Januar 1987 (1987-01), Seiten 87-93, XP009023787 ISSN: 0885-8977

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Störgrößenkompensation eines optischen Sensors, bei dem ein Lichtsignal im optischen Sensor mindestens in Abhängigkeit von einer zu detektierenden Messgröße, einer Wellenlänge des eingespeisten Lichtsignals und einer Störgröße beeinflusst wird. Außerdem betrifft die Erfindung eine Vorrichtung zur Störgrößenkompensation eines optischen Sensors, wobei der von einem Lichtsignal durchlaufene optische Sensor mindestens empfindlich gegenüber einer Messgröße, einer Wellenlänge des Lichtsignals und einer Störgröße ist.

Ein solches Verfahren und eine solche Vorrichtung sind beispielsweise aus der *US 5,764,046* oder aus der *WO 95/10046 A1* bekannt. Bei diesen bekannten Verfahren und Vorrichtungen wird mittels eines als Faraday- oder Pockels-Sensor ausgebildeten optischen Sensors ein Messwert für eine magnetische Feldstärke oder eine elektrische Feldstärke ermittelt. Über eine geeignete Sensoranordnung und Auswertung kann mittels eines Faraday-Sensors auch ein elektrischer Strom und mittels eines Pockels-Sensors eine elektrische Spannung detektiert werden. Sowohl der Faraday-Effekt als auch der Pockels-Effekt beruhen auf einer messgrößenabhängigen Beeinflussung des Polarisationszustands des in den optischen Sensor eingespeisten Eingangslichtsignals.

Bei beiden Sensortypen hängt die Messempfindlichkeit von der Wellenlänge des in den jeweiligen optischen Sensor eingespeisten Lichtsignals ab. Diese Wellenlängenabhängigkeit wird unter anderem auch zur Einstellung der Sensorempfindlichkeit herangezogen.

Eine Veränderung des Polarisationszustandes wird jedoch nicht nur durch die zu detektierenden Messgrößen (z.B. magnetisches oder elektrisches Feld) hervorgerufen, sondern auch durch gewisse Umgebungsbedingungen, wie z.B. die Umgebungstemperatur oder eine mechanische Vibration des optischen Sensors. Zur Kompensation dieser unerwünschten Störgrößeneinflüsse werden in der US 5,764,046 und in der WO 95/10046 A1 Verfahren beschrieben, die sich im Wesentlichen einer geeigneten Auswertung des im Empfänger empfangenen Ausgangslichtsignals bedienen.

Bei dieser Kompensationsmethode wird der Einfluss der Störgröße erst nachträglich im Rahmen der Signalauswertung extrahiert. Dabei ist es durchaus möglich, dass keine vollständige Trennung zwischen messgrößenabhängigem und störgrößenabhängigem Anteil im Ausgangslichtsignal erreicht werden kann. Folglich kommt es bei diesem Kompensationsverfahren zu Fehlern, und die Messgröße lässt sich nur ungenau ermitteln.

Um das Problem der nachträglich nicht mehr möglichen Separierung zwischen Mess- und Störgröße zu vermeiden, wird in dem Fachaufsatz von *T. Mitsui* et *al. "Development of Fiber-Optic Voltage Sensors and Magnetic-Field Sensors" in IEEE Transactions on Power Delivery, Vol. PWRD-2, No. 1, 1987, Seiten 87 bis 93,* ein Temperaturkompensationsverfahren für einen Pockels-Sensor beschrieben, bei dem die Kompensation des störenden Temperatureinflusses unmittelbar im Pockels-Sensor selbst erfolgt. Dazu wird für den Pockels-Sensor ein spezieller Aufbau eingesetzt, bei dem sich die Temperaturabhängigkeit des für die Messgrößendetektion verwendeten Pockels-Effekts gerade mit der Temperaturabhängigkeit der optischen Aktivität weitestgehend gegenseitig aufhebt. Dies bedeutet, dass die im beschriebenen Pockels-Sensor erfolgende messgrößenabhängige Beeinflussung des Eingangslichtsignals weitgehend unabhängig von der Störgröße Umgebungstemperatur beeinflusst wird. Eine nachträgliche Separierung im messgrößenabhängigen und störgrößenabhängigen Anteil im Ausgangslichtsignal ist also nicht erforderlich. Die in dem Fachaufsatz beschriebene, besonders vorteilhafte Kompensationsmethode ist allerdings nur für den speziellen Anwendungsfall, d.h. bei genau dieser Materialwahl und bei genau diesen geometrischen Abmessungen des Pockels-Sensors, möglich. Sie ist eine Speziallösung und lässt sich nicht auf andere optische Sensoren übertragen.

In der *US 6,016,702* ist ein Kompensationsverfahren für einen anderen Sensortyp, nämlich einen Bragg-Gitter-Sensor, beschrieben. Neben einem optischen Sensor ist ein zusätzliches Kompensationselement vorgesehen, die beide jeweils als Bragg-Gitter-Element mit voneinander verschiedener Bragg-Wellenlänge ausgebildet sind. Im Sensor erfolgt eine Beeinflussung der Wellenlänge durch die Messgröße und die Störgröße, im Kompensationselement dagegen nur durch die Störgröße. Die Kompensationswirkung beruht im Wesentlichen darauf, dass die beiden Wellerilängenverschiebungen voneinander subtrahiert werden. Die Differenz der Wellenlängenverschiebungen weist dann nur noch eine Abhängigkeit von der Messgröße auf. Die Kompensation erfolgt also in einer separaten Auswerteeinheit, in der die Wellenlängen-Subtraktion vorgenommen wird.

In der Patentschrift US 4,269,483 ist ein auf dem elektro-optischen Effekt (Pockels-Effekt) basierendes Spannungsmessgerät angegeben. Da der elektro-optischen Effekt temperaturabhängig ist, stellt die Temperatur dabei eine Störgröße dar. Zur Kompensation der Temperaturbeeinflussung sind beispielsweise drei doppel-brechende Lichtwel-lenleiter derart nacheinander angeordnet, dass sich der elektro-optische Effekt der beiden ersten Lichtwellenleiter zunächst addiert und dann von dieser Summe der elektro-optische Effekt des dritten Lichtwellenleiters abgezogen wird. Dadurch, dass jeder der Lichtwellenleiter einen vergleichbar ausgeprägten elektro-optischen Effekt aufweist und der dritte Lichtwellenleiter jedoch eine verglichen mit den beiden vorangehenden Lichtwellenleiter viel größere Temperaturabhängigkeit hat, verlässt der Lichtstrahl nach Addition und anschließender Differenzbildung den dritten Lichtwellenleiter nahezu temperaturkompensiert.

Die Aufgabe der Erfindung besteht deshalb darin, ein Verfahren und eine Vorrichtung der eingangs bezeichneten Art anzugeben, so dass eine möglichst gute Störgrößenkompensation insbesondere auch für verschiedene Typen von optischen Sensoren möglich ist.

Zur Lösung der das Verfahren betreffenden Aufgabe wird ein Verfahren entsprechend den Merkmalen des unabhängigen Patentanspruchs 1 angegeben.

Zur Lösung der die Vorrichtung betreffenden Aufgabe wird eine Vorrichtung entsprechend den Merkmalen des unabhängigen Patentanspruchs 4 angegeben.

Die Erfindung beruht auf der Erkenntnis, dass viele verschiedene Typen von optischen Sensoren neben der erwünschten Messgrößenempfindlichkeit auch eine Abhängigkeit von mindestens einer Störgröße und darüber hinaus auch von der Wellenlänge des eingespeisten Lichtsignals aufweisen. Bei den bekannten Verfahren und Vorrichtungen zur optischen Messgrößenerfassung spielt die zuletzt genannte Abhängigkeit normalerweise keine Rolle, da die Wellenlänge einmal bei der Erzeugung des Eingangslichtsignals gewählt wird und sich dann üblicherweise nicht mehr verändert. Anders verhält es sich dagegen mit dem Störgrößeneinfluss, der sehr wohl die Erfassung der Messgröße im optischen Sensor behindert.

Es wurde nun erkannt, dass sich die Wellenlängenabhängigkeit des optischen Sensors gezielt zu einer Kompensation der Störgrößenabhängigkeit einsetzen lässt. Dazu wird in einem gesonderten Kompensationselement bewusst eine Wellenlängenänderung herbeigeführt. Diese Wellenlängenänderung ist gerade so groß, dass sich die im optischen Sensor aufgrund dieser Wellenlängenänderung einstellende Teilbeeinflussung gerade mit der durch die Störgröße bedingten Teilbeeinflussung des Eingangslichtsignals gegenseitig aufhebt.

Besonders günstig ist es, wenn die Wellenlängenänderung im Kompensationselement automatisch durch die gleiche Störgröße herbeigeführt wird, deren Einfluss im optischen Sensor kompensiert werden soll. Dazu wird das Kompensationselement in entsprechender Art und Weise ausgestaltet. Dies erfolgt beispielsweise mit Hilfe vorab ermittelter Messwerte oder vorab durchgeführter Berechnungen für die Abhängigkeit des optischen Sensors sowohl von der Wellenlänge als auch von der zu kompensierenden Störgröße. Dann lässt sich ein quasi inverser Zusammenhang zwischen der Wellenlänge und der Störgröße ermitteln, der zur gegenseitigen Kompensation der wellenlängenabhängigen und der störgrößenabhängigen Teilbeeinflussungen im optischen Sensor erforderlich ist. Der so ermittelte Zusammenhang zwischen Wellenlänge bzw. Wellenlängenänderung und der Störgröße wird dann für die gezielte Ausgestaltung des Kompensationselementes verwendet. Das Kompensationselement wird also gemäß diesem Zusammenhang modelliert.

Mit dieser Kompensationsmethode wird erreicht, dass im optischen Sensor das Lichtsignal weitgehend nur durch die zu erfassende Messgröße beeinflusst wird. Damit erhält man eine genauere Messgrößenerfassung als bei einer erst nachträglichen Eliminierung des störgrößenbedingten Einflusses in der Auswerteeinheit. Außerdem ist das Kompensationsverfahren auch für unterschiedliche Typen von optischen Sensoren einsetzbar. Es ist insbesondere nicht auf ein bestimmtes Material oder eine bestimmte Sensorgeometrie beschränkt. Das Verfahren ist beispielsweise auf einen Pockels-Sensor oder auch auf einen Faraday-Sensor anwendbar. Der Faraday-Sensor kann dabei als Transmissions- oder als Reflexionssensor und auch als Glasring- oder als faseroptischer Sensor ausgeführt sein. Daneben ist selbstverständlich auch ein Einsatz bei anderen optischen Sensortypen möglich.

Besondere Ausgestaltungen des Verfahrens und der Vorrichtung ergeben sich aus den von Anspruch 1 bzw. Anspruch 4 jeweils abhängigen Ansprüchen.

Günstig ist eine Ausführungsform, bei der das Kompensationselement in Form eines Bragg-Gitters ausgebildet ist. Von einem auf ein solches Bragg-Gitter auftreffendes Lichtsignal wird eine bestimmte Wellenlänge oder auch ein bestimmter Wellenlängenanteil reflektiert. Welche Wellenlänge oder welcher Wellenlängenanteil von dem Bragg-Gitter reflektiert wird, hängt von der Gitterperiode des Bragg-Gitters und der Brechzahl des lichtführenden Mediums ab. Wird diese Gitterperiode oder diese Brechzahl unter dem Einfluss der Störgröße verändert, kommt es folglich auch zu einer störgrößenabhängigen Veränderung des Wellenlängenanteils im reflektierten Signal. Nach den vorstehenden Ausführungen wird gerade dieses Verfahren für das Kompensationselement benötigt.

Es gibt bevorzugte Ausführungsformen, bei denen die zu kompensierende Störgröße in Form einer Temperatur, beispielsweise einer Umgebungstemperatur, oder auch in Form einer mechanischen Vibration, der der optische Sensor ausgesetzt ist, vorliegt. Wenn das Kompensationselement praktisch dem gleichen Störgrößeneinfluss, also beispielsweise der gleichen Umgebungstemperatur oder der gleichen mechanischen Vibration, ausgesetzt ist wie der optische Sensor, erreicht man eine besonders gute Störgrößenkompensation des optischen Sensors.

Bei einer weiteren bevorzugten Variante wird die vorstehend angesprochene Modellierung des Kompensationselements entsprechend einem gewünschten, vorab ermittelten Zusammenhang zwischen der Wellenlängenänderung und der Störgröße unter Zuhilfenahme eines Gehäuses bewerkstelligt. Durch eine spezielle Ausgestaltung, beispielsweise Formgebung, des Gehäuses kann erreicht werden, dass sich die Wellenlänge unter dem Störgrößeneinfluss im Kompensationselement nach der gewünschten vorbestimmten Art und Weise ändert. Diese gewünschte vorbestimmte Art und Weise ergibt sich aus der vorab ermittelten Störgrößen- und Wellenlängenabhängigkeit des optischen Sensors.

Alternativ oder auch zusätzlich zum Gehäuse kann das Kompensationselement eine Beschichtung aufweisen, die die gewünschte Wellenlängenbeeinflussung durch die Störgröße mit herbeiführt.

Bevorzugte Ausführungsbeispiele werden nunmehr anhand der Zeichnung näher erläutert. Zur Verdeutlichung ist die Zeichnung nicht maßstäblich ausgeführt und gewisse Merkmale sind schematisiert dargestellt. Im Einzelnen zeigen

Figur 1 und 2    jeweils eine Vorrichtungsanordnung zur störgrößenkompensierten optischen Messwerterfassung mittels eines Kompensationselements

Figur 3    ein Kompensationselement mit Gehäuse für einen Einsatz in den Vorrichtungen gemäß Figur 1 oder 2 und

Figur 4    ein Kompensationselement mit Beschichtung für einen Einsatz in den Vorrichtungen gemäß Figur 1 oder 2.

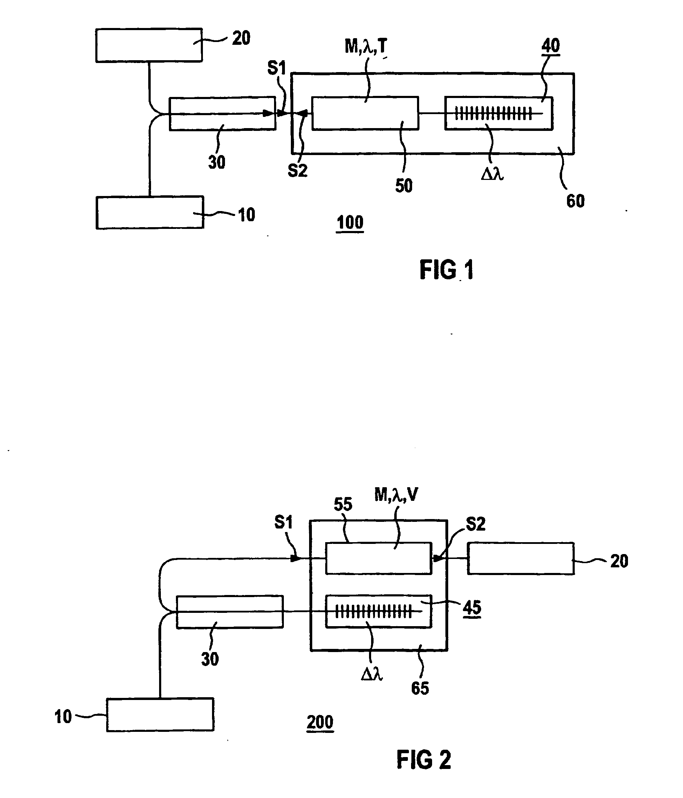

Einander entsprechende Teile sind in den Figuren 1 bis 4 mit denselben Bezugszeichen versehen.

In Figur 1 ist eine Vorrichtung 100 zur störgrößenkompensierten optischen Messwerterfassung dargestellt. Die Vorrichtung 100 umfasst einen optischen Sensor 50, der zur Erfassung einer Messgröße M bestimmt ist. Zum Betrieb des Sensors 50 wird ein von einer Lichtquelle 10 erzeugtes Eingangslichtsignal S1 über ein Koppelelement 30 dem Sensor 50 zugeführt. Das Eingangslichtsignal S1 passiert den Sensor 50 und erfährt hierbei eine messgrößenabhängige Veränderung. Neben der erwünschten Messgrößenempfindlichkeit weist der Sensor 50 jedoch auch eine unerwünschte Empfindlichkeit gegenüber einer Störgröße im vorliegenden Fall gegenüber der Umgebungstemperatur T auf. Deshalb wird das Eingangslichtsignal S1 beim Passieren des Sensors 50 nicht nur durch die Messgröße M, sondern auch durch die Temperatur T beeinflusst.

Um diesen unerwünschten Störgrößeneinfluss im Sensor 50 zu kompensieren, ist dem Sensor 50 ein Kompensationselement 40 nachgeschaltet, in dem das Eingangslichtsignal S1 reflektiert wird, so dass es den Sensor 50 erneut durchläuft. Die kompensierende Wirkung beruht auf einer zusätzlich im optischen Sensor 50 vorhandenen Wellenlängenabhängigkeit der Messgrößenempfindlichkeit. Die Beeinflussung im optischen Sensor 50 findet also auch in Abhängigkeit von einer Wellenlänge $\lambda$ des den Sensor 50 passierenden Lichtsignals statt. Durch das Kompensationselement 40 wird die Wellenlänge $\lambda$ so verändert, dass sich die störgrößenabhängige Teilbeeinflussung und die wellenlängenabhängige Teilbeeinflussung im optischen Sensor 50 praktisch komplett gegenseitig aufheben.

Das Kompensationselement 40 ist deshalb gerade so ausgestaltet, dass es eine Änderung $\Delta\lambda$ in dem reflektierten Wellenlängengehalt herbeiführt, die abhängig von der in diesem Ausführungsbeispiel als Störgröße vorliegenden Umgebungstemperatur T ist. Die durch das Kompensationselement 40 bewirkte Wellenlängenänderung $\Delta\lambda$ ist gerade so groß, dass der beschriebene Kompensationseffekt der beiden Teilbeeinflussungen im optischen Sensor 50 eintritt.

Das Kompensationselement 40 ist als Faser-Bragg-Gitter ausgebildet, dessen wellenlängenbeeinflussendes Verhalten gerade an die diesbezüglichen Erfordernisse des Sensors 50 angepasst ist. Um eine möglichst gute Kompensation zu erreichen, werden für den im jeweiligen Anwendungsfall eingesetzten optischen Sensor 50 zunächst Messwerte für die wellenlängenabhängige Beeinflussung und auch für die störgrößenabhängige Teilbeeinflussung ermittelt. Daraus lässt sich ein Zusammenhang zwischen der Wellenlänge $\lambda$ und der Störgröße T ermitteln, dem für jeden Wert der Störgröße T zu entnehmen ist, in welcher Weise die Wellenlänge $\lambda$ verändert werden muss, um im optischen Sensor 50 eine möglichst vollständige Kompensation zu erreichen. Das Kompensationselement 40 wird dann gerade nach diesem ermittelten Zusammenhang ausgestaltet.

Bei einem als Faser-Bragg-Gitter ausgestalteten Kompensationselement 40 erfolgt eine durch die Bragg-Gitter-Periode und die Brechzahl des lichtführenden Mediums bestimmte wellenlängenselektive Reflexion des eingestrahlten Lichtsignals. Durch entsprechende Maßnahmen kann die Wellenlänge $\lambda$ des am Faser-Bragg-Gitter reflektierten Lichtanteils in der gewünschten Weise von der hier als Störgröße vorliegender Umgebungstemperatur T abhängig gemacht werden. Wenn sich dann sowohl der optische Sensor 50 als auch das Kompensationselement 40 in einem gemeinsamen Störgrößeneinwirkungsbereich 60 befinden, weist der optische Sensor 50 eine besonders gute Kompensation des störenden Einflusses der Umgebungstemperatur T auf. Im gemeinsamen Störgrößeneinwirkungsbereich, der im Ausführungsbeispiel von Figur 1 als isothermer Bereich ausgebildet ist, unterliegen der Sensor 50 und das Kompensationselement 40 den gleichen Schwankungen der Umgebungstemperatur T.

Von dem breitbandigen Eingangslichtsignal S1 wird in dem Kompensationselement 40 ein Anteil reflektiert, dessen Wellen-Wellenlänge $\lambda$ oder dessen Schwerpunktwellenlänge in der vorab festgelegten Weise in Abhängigkeit von der Umgebungstemperatur T verändert worden ist. Dieser reflektierte Anteil durchläuft den Sensor 50 erneut und wird bei der Passage aufgrund der Störgrößenkompensation im Wesentlichen nur noch durch die zu detektierende Messgröße M beeinflusst. Als Ausgangssignal S2 verlässt dieses die Information über die Messgröße M tragende Lichtsignal den Sensor 50 und wird über das Koppelelement 30 einem Empfänger 20 zugeführt. Hier erfolgt eine Auswertung und eine Berechnung des Messwerts für die Messgröße M.

Das beschriebene Kompensationsverfahren ist nicht auf einen speziellen Typ eines optischen Sensors 50 beschränkt. Es eignet sich beispielsweise für einen als Pockels-Sensor oder einen als Faraday-Sensor ausgebildeten optischen Sensor 50. Ebenso ist der Anwendungsbereich nicht auf die Umgebungstemperatur T als einzige zu kompensierende Störgröße beschränkt.

In Figur 2 ist eine andere Vorrichtung 200 zur störgrößenkompensierten optischen Messwerterfassung dargestellt, bei der als Störgröße nicht die Umgebungstemperatur T, sondern eine mechanische Vibration V, der ein anderer optischer Sensor 55 ausgesetzt ist, zu kompensieren ist. Ähnlich wie bei der Anordnung 100 von Figur 2 befindet sich auch der optische Sensor 55 gemeinsam mit einem Kompensationselement 45, das wiederum als Faser-Bragg-Gitter ausgeführt ist, in einem gemeinsamen Störgrößeneinwirkungsbereich 65. Wiederum sind also der Sensor 55 und das Kompensationselement 45 gleichermaßen der Störgröße, hier der mechanischen Vibration V, ausgesetzt. Auch bei der Anordnung 200 bewirkt das Kompensationselement 45 eine von der Störgröße abhängige Wellenlängenveränderung im Eingangslichtsignal S1.

Sowohl bei der Vorrichtung 100 als auch bei der Vorrichtung 200 emittiert die Lichtquelle 10 ein Wellenlängenspektrum mit einer spektralen Bandbreite, die den gesamten Wellenlängenbereich abdeckt, innerhalb dessen die Wellenlängenveränderung $\Delta\lambda$ des Kompensationselements 40 bzw. 45 unter dem Störgrößeneinfluss erfolgen kann. Je nach Ausführungsform des für das Kompensationselement 40 bzw. 45 gewählten Faser-Bragg-Gitters kann der von dem Faser-Bragg-Gitter reflektierte Anteil des Eingangslichtsignals S1 eine spektrale Breite von einigen 100 pm bei einem uniformen Faser-Bragg-Gitter bis zu mehreren Nanometern bei einem gechirpten Faser-Bragg-Gitter haben.

Die Vorrichtung 200 unterscheidet sich von der Vorrichtung 100 in dem Lichtweg, den das Eingangslichtsignal S1 zurücklegt. Nach Erzeugung in der Lichtquelle 10 wird das Eingangslichtsignal S1 über den Faserkoppler 30 diesmal zunächst dem Kompensationselement 45 zugeführt. Hier kommt es zu der unter anderem auch durch die mechanische Vibration V bestimmte wellenlängenselektive Reflexion. Das so reflektierte Lichtsignal wird über das Koppelelement 30 dann dem optischen Sensor 55 zugeführt. Nach bei diesem Ausführungsbeispiel nur einmaligem Durchlaufen des optischen Sensors 55 wird das durch die Messgrößenbeeinflussung modifizierte Ausgangslichtsignal S2 dem Empfänger 20 zugeführt. Trotz der Unterschiede in der Lichtwegführung erfolgt die Störgrößenkompensation bei der Vorrichtung 200 analog zu dem im Zusammenhang mit der Vorrichtung 100 beschriebenen Prinzip. Es ergeben sich die gleichen vorteilhaften Wirkungen.

Die kompensierende Wirkungsweise wird nochmals anhand von einfachen mathematischen Formelbeziehungen erläutert. Das Eingangslichtsignal S1 erfährt in dem optischen Sensor 50 bzw. 55 eine Beeinflussung, die im Folgenden als $f_{Sensor}$ bezeichnet wird. Das Eingangslichtsignal S1 kann weitgehend beliebig beeinflusst werden, insbesondere in seinem Polarisationszustand, in der Intensität, in der Phase, usw.. Die Beeinflussungsfunktion $f_{Sensor}$ ist abhängig von den drei Einflussgrößen Messgröße M, Wellenlänge $\lambda$ und Störgröße (hier beispielhaft als Temperatur T angenommen). Sie lässt sich mittels der folgenden Gleichung darstellen:

$$f_{Sensor} = f(M, \lambda, T) = f_1(M) \circ f_2(\lambda) \circ f_3(T) \tag{1}$$

wobei das Zeichen "o" für eine beliebige Verknüpfungsoperation, beispielsweise Multiplikation, Summation oder ähnliches, steht. Vereinfachend aber keineswegs einschränkend ist außerdem angenommen worden, dass sich die Gesamtfunktion $f_{Sensor}$ als im vorstehend genannten Sinne zu verstehende Verknüpfung von drei voneinander unabhängigen Teilbeeinflussungsfunktionen $f_1$, $f_2$ und $f_3$, die jeweils nur von einer der drei Einflussgrößen M, $\lambda$ und T abhängen, darstellen lässt.

Im Kompensationselement 40 bzw. 45 erfährt das Eingangslichtsignal S1 ebenfalls eine Beeinflussung, die allerdings nur von der Störgröße, also der Temperatur T, abhängt und die hier mit dem Symbol $f_{Komp}$ bezeichnet wird:

$$f_{Komp} = f_4(T) = \lambda(T) = \lambda_0 + \Delta\lambda(T) \tag{2}$$

Mit $\lambda_0$ ist eine Schwerpunkt-Wellenlänge, insbesondere die Bragg-Wellenlänge des als Faser-Bragg-Gitter ausgebildeten Kompensationselements 40 bzw. 45, und mit $\Delta\lambda$ die Wellenlängenänderung oder -verschiebung bezeichnet. Unter dem Einfluss der Temperatur T verschiebt sich die Wellenlänge $\lambda$ um $\Delta\lambda$. Im Kompensationselement 40 bzw. 45 werden also zwei der drei Einflussgrößen von Gleichung (1) in Beziehung zueinander gesetzt.

Durch Einsetzen von Gleichung (2) in Gleichung (1) ergibt sich:

$$f_{Sensor} = f_1(M) \circ f_2(\lambda(T)) \circ f_3(T) = \dot{f_1}(M)$$

Dadurch, dass das Eingangslichtsignal S1 sowohl das Kompensationselement 40 bzw. 45 als auch den Sensor 50 bzw. 55 durchläuft, bewirkt die im Kompensationselement 40 bzw. 45 hervorgerufene Wellenlängenänderung $\Delta\lambda(T)$ im Sensor 50 bzw. 55 eine modifizierte Teilbeeinflussung $f_2$. Das Kompensationselement 40 bzw. 45 ist gerade so ausgelegt, dass die durch die Störgrößetemperatur T im Kompensationselement 40 bzw. 45 hervorgerufene Wellenlängenänderung $\Delta\lambda(T)$ im optischen Sensor 50 bzw. 55 zu einer Teilbeeinflussung $f_2$ führt, die die Störgrö-ßen-Teilbeeinflussung $f_3$ praktisch kompensiert. Die Verknüpfung $f_2(\lambda(T))$o $f_3(T)$ ergibt dann gerade den Einheitsoperator. Die Kompensation erfolgt unmittelbar am Ort des Sensors 50 bzw. 55 selbst. Es ist hierfür also keine gesonderte Auswerteeinheit erforderlich, wodurch sich der Aufwand reduziert.

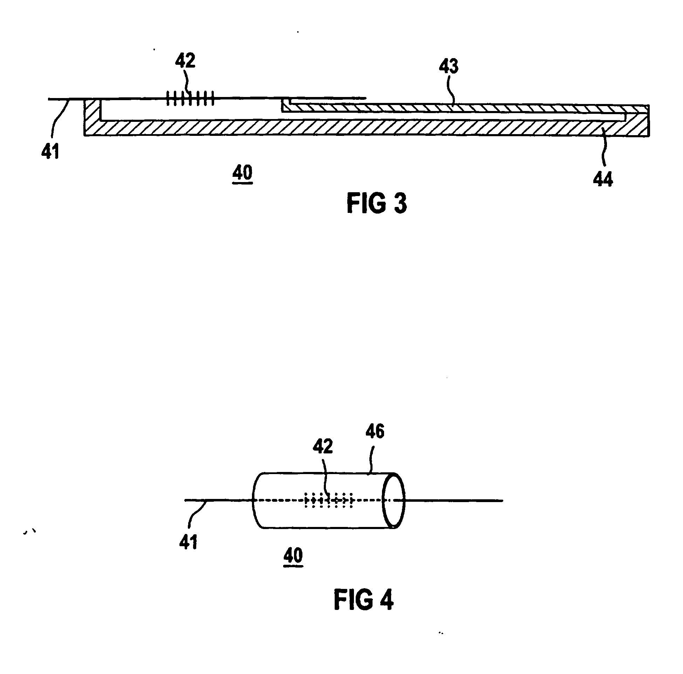

Für die Vorrichtungen 100 und 200 wird jeweils ein Kompensationselement 40 bzw. 45 benötigt, das in vorgegebener Art und Weise eine von der Störgröße abhängige Wellenlängenänderung im reflektierten Lichtsignal hervorruft. In den Figuren 3 und 4 sind Ausführungsbeispiele für ein solches Kompensationselement 40 dargestellt, das einen speziell nach der gewünschten Temperturabhängigkeit modellierten Aufbau aufweist. Bei Bedarf kann die Nachbildung der gewünschten Temperaturabhängigkeit auch abschnittsweise mit linearisierten Näherungen erfolgen.

Bei dem Beispiel von Figur 3 ist zumindest der Teil eines Lichtwellenleiters 41, in dem ein Faser-Bragg-Gitter 42 angeordnet ist, in einem Gehäuse untergebracht. Der Lichtwellenleiter 41 ist im Bereich des Faser-Bragg-Gitters 42 zwischen zwei Gehäuseteilen 43 und 44 angeordnet. Beide Gehäuseteile 43 und 44 weisen eine unterschiedliche Temperaturausdehnung auf. So ist beispielsweise das Gehäuseteil 43 aus einem Material mit großer Temperaturdehnung und das Gehäuseteil 44 aus einem Material mit geringer Temperaturdehnung hergestellt. Durch eine entsprechende Material- und auch Geometriewahl für die Gehäuseteile 43 und 44 lässt sich damit ein von der Temperatur T abhängiges Reflexionsverhalten des Faser-Bragg-Gitters 42 einstellen. Insbesondere ist es aufgrund der im Ausführungsbeispiel von Figur 3 vorgesehenen Vorspannung des Lichtwellenleiters 41 zwischen den Gehäuseteilen 43 und 44 auch möglich, eine negative auf die Temperaturänderung bezogene Wellenlängenänderung (= negativer Wellenlängen-Temperatur-Gradient) vorzusehen.

Andere mögliche Gehäuseformen und Anordnungen zur Krafteinwirkung auf ein Faser-Bragg-Gitter sind in der *DE 199 39 583 A1* beschrieben. Durch die Verwendung eines Gehäuses kann also die natürliche Temperaturdehnung eines in einem Lichtwellenleiter 41 angeordneten Faser-Bragg-Gitters 42 verstärkt und auch mit gewünschter Temperaturabhängigkeit ausgebildet werden. Eine entsprechende Abhängigkeit von einer anderen Störgröße, beispielsweise der mechanischen Vibration V, lässt sich in ähnlicher Weise realisieren.

Wie in Figur 4 gezeigt kann das Kompensationselement 40 mit dem in dem Lichtwellenleiter 41 angeordneten Faser-Bragg-Gitter 42 anstelle eines Gehäuses auch eine Beschichtung 46 aufweisen. Die Beschichtung 46 ist so ausgewählt, dass die Störgröße eine Wellenänderung $\Delta\lambda$ in der gewünschten Art und Weise bewirkt.

Eine Kombination der beiden Ausführungsformen von Figur 3 und 4 ist ebenfalls möglich. Es kann also auch ein beschichteter und in einem Gehäuse angeordneter Lichtwellenleiter 41 verwendet werden.

Beispielhaft wird im Folgenden die Auslegung des Kompensationselements 40 für einen magnetfeld- oder stromempfindlichen optischen Sensor 50 erläutert. Die Messgrößen-Empfindlichkeit wird bei diesem Sensortyp durch die sogenannte Verdet-Konstante bestimmt. Die Verdet-Konstante zeigt nicht nur eine Abhängigkeit von der zu detektierenden Größe, hier dem Magnetfeld, sondern auch eine Abhängigkeit von der zu kompensierende Störgröße, hier der Temperatur, sowie von der Wellenlänge $\lambda$ des eingespeisten Lichtsignals S1.

Die Temperaturabhängigkeit der Verdet-Konstante beläuft sich in dem Temperatureinsatzbereich des Sensors 50 auf etwa zwischen 0.01 %/°C und 0.02 %/°C. Es wird in dem hier betrachteten Temperatureinsatzbereich zwischen -40°C und +80°C eine lineare Temperaturabhängigkeit der Verdet-Konstante angenommen. Das Messergebnis weist über den gesamten Temperaturbereich $\Delta T$ von 120°C dann eine temperaturbedingte Abweichung von zwischen $\pm 0.6$ % und $\pm 1.2$ % auf. Diesen unerwünschten Einfluss gilt es zu kompensieren.

Die Wellenlängenabhängigkeit der Verdet-Konstante beträgt beispielsweise -0.0003 %/pm (siehe *"Verdet Constant Dispersion in Annealed Optical Fiber Current Sensors" von A. H. Rose et al., Journal of Lightwave Technology, Vol. 15, No. 5, 1997, Seiten 803 bis 807).* Zur Kompensation der ermittelten temperaturbedingten Abweichung von zwischen $\pm 0.6$ % und $\pm 1.2$ % sollte das Kompensationselement 40 also eine von der Temperatur abhängige Wellenlängenänderung von zwischen 33 pm/°C und 66 pm/°C aufweisen. Über den gesamten Temperaturbereich $\Delta T$ von 120°C resultiert dann eine Wellenänderung von zwischen 4 nm und 8 nm, wobei das im hier betrachteten Beispiel eingesetzte Faser-Bragg-Gitters 42 eine Schwerpunktwellenlänge von etwa 850 nm hat.

Die natürliche Temperaturabhängigkeit der Wellenlängenverschiebung in dem Faser-Bragg-Gitters 42 liegt in der Größenordnung von etwa 6.5 pm/°C, also zu niedrig im Vergleich zu dem für eine Kompensation benötigten Wert zwischen 33 pm/°C und 66 pm/°C. Deshalb wird die Temperaturabhängigkeit durch den Einsatz einer entsprechenden Beschichtung 46 gesteigert. So wird beispielsweise bei Verwendung des in *"Enhanced pressure and temperature sensitivity of a fiber Bragg grating with polymer packaging" von Y. Liu et al., SPIE, Vol. 3740, 1999, Seiten 284 bis 287* beschriebenen Polymers als Material für die Beschichtung 46 mit 50 pm/°C ein Wert erreicht, der gerade in dem hier benötigten Bereich zwischen 33 pm/°C und 66 pm/°C liegt. Entsprechend lässt sich mit einem anderen Beschichtungsmaterial auch eine andere geforderte durch die Temperatur oder eine andere zu kompensierende Störgröße bedingte Wellenlängenänderung im Kompensationselement 40 erzielen.

**Patentansprüche**

**1.** Verfahren zur Störgrößenkompensation eines optischen Sensors (50, 55), bei dem

a) ein Lichtsignal (S1) im optischen Sensor (50, 55) mindestens in Abhängigkeit von einer zu detektierenden Messgröße (M), von einer Wellenlänge ($\lambda$) des eingespeisten Lichtsignals (S1) und von einer Störgröße (T, V) beeinflusst wird,
**dadurch gekennzeichnet, dass**
b) das Lichtsignal (S1) in ein Kompensationselement (40, 45) eingespeist wird, wobei sich das Kompensationselement (40, 45) zusammen mit dem optischen Sensor (50, 55) in einem gemeinsamen Störgrößeneinwirkungsbereich (60, 65) mit weitgehend gleicher Einwirkung der Störgröße (T, V) auf den optischen Sensor (50, 55) und auf das Kompensationselement (40, 45) befindet,
c) das Lichtsignal (S1) im Kompensationselement (40, 45) eine Wellenlängenänderung ($\Delta\lambda$) erfährt,
d) die Wellenlängenänderung ($\Delta\lambda$) im Kompensationselement (40, 45) von der Störgröße (T, V) beeinflusst wird,
e) das Lichtsignal (S1) mit von der Störgröße (T, V) beeinflusst veränderter Wellenlänge ($\lambda$) in den optischen Sensor (50, 55) eingespeist wird
und
f) sich die im optischen Sensor (50, 55) erfolgenden Teilbeeinflussungen aufgrund der von der Störgröße (T, V) beeinflusst veränderten Wellenlänge ($\lambda$) und aufgrund der Störgröße (T, V) zumindest weitgehend gegenseitig im optischen Sensor (50, 55) aufheben.

**2.** Verfahren nach Anspruch 1, bei dem das Lichtsignal (S1) in einem als Bragg-Gitter (40, 45) ausgebildeten Kompensationselement in seiner Wellenlänge verändert wird.

**3.** Verfahren nach Anspruch 1 oder 2, bei dem im optischen Sensor (50, 55) die störgrößenabhängige Teilbeeinflussung des Lichtsignals (S1) durch eine Temperatur (T) oder eine Vibration (V) hervorgerufen wird.

**4.** Vorrichtung zur Störgrößenkompensation eines optischen Sensors (50, 55), wobei

a) der von einem Lichtsignal (S1) durchlaufene optische Sensor (50, 55) mindestens empfindlich gegenüber einer Messgröße (M), einer Wellenlänge ($\lambda$) des Lichtsignals (S1) und einer Störgröße (T, V) ist,
**gekennzeichnet durch**
b) ein Kompensationselement (40, 45),

c) in welches das Lichtsignal (S1) einzuspeisen ist und
d) in welchem die Wellenlänge ($\lambda$) des Lichtsignals (S1) änderbar ist,

wobei
e) sich das Kompensationselement (40, 45) zusammen mit dem optischen Sensor (50, 55) in einem gemeinsamen Störgrößeneinwirkungsbereich (60, 65) mit weitgehend gleicher Einwirkung der Störgröße (T, V) auf den optischen Sensor (50, 55) und das Kompensationselement (40, 45) befindet,
f) die Wellenlängenänderung ($\Delta\lambda$) von der Störgröße (T, V) beeinflussbar ist,
g) das Lichtsignal (S1) mit von der Störgröße (T, V) beeinflusst veränderter Wellenlänge ($\lambda$) in den optischen Sensor (50, 55) einspeisbar ist
und
h) die im optischen Sensor (50, 55) erfolgenden Teilbeeinflussungen aufgrund der von der Störgröße (T, V) beeinflusst veränderten Wellenlänge ($\lambda$) und aufgrund der Störgröße (T, V) zumindest weitgehend gegenseitig im optischen Sensor (50, 55)-kompensierbar sind.

**5.** Vorrichtung nach Anspruch 4, bei der das Kompensationselement als Bragg-Gitter (40, 45) ausgebildet ist.

**6.** Vorrichtung nach Anspruch 4 oder 5, bei der das Kompensationselement (40, 45) ausgelegt ist für eine in Form einer Temperatur (T) oder einer Vibration (V) vorliegenden Störgrö-ße.

**7.** Vorrichtung nach einem der Ansprüche 4 bis 6, bei der das Kompensationselement (40, 45) ein Gehäuse (43, 44) umfasst, und die Ausgestaltung des Gehäuses (43, 44) mit dazu beiträgt, dass die Wellenlängenänderung (Δλ) unter dem Einfluss der Störgröße (T, V) in vorbestimmter Weise erfolgt.

8. Vorrichtung nach einem der Ansprüche 4 bis 7, bei der das Kompensationselement (40, 45) eine Beschichtung (46) umfasst.

**Claims**

1. Method of compensating for interfering variables in an optical sensor (50, 55), in which

   a) an optical signal (S1) is influenced in the optical sensor (50, 55) at least as a function of a measured variable (M) to be detected, of a wavelength (λ) of the optical signal (S1) fed in and of an interfering variable (T, V), **characterized in that**
   b) the optical signal (S1) is fed into a compensation element (40, 45), the compensation element (40, 45) together with the optical sensor (50, 55) being located in a common interfering variable effect region (60, 65) with largely equal effect of the interfering variable (T, V) on the optical sensor (50, 55) and on the compensation element (40, 45),
   c) the optical signal (S1) undergoes a wavelength change (Δλ) in the compensation element (40, 45)
   d) the wavelength change (Δλ) in the compensation element (40, 45) is influenced by the interfering variable (T, V),
   e) the optical signal (S1) with the change in wavelength (λ) influenced by the interfering variable (T, V) is fed into the optical sensor (50, 55)
   and
   f) the partial influences which are exerted in the optical sensor (50, 55) on account of the change in wavelength (λ) influenced by the interfering variable (T, V) and on account of the interfering variable (T, V) at least largely cancel one another out in the optical sensor (50, 55).

2. Method according to Claim 1, in which the wavelength of the optical signal (S1) is changed in a compensation element designed as a Bragg grating (40, 45).

3. Method according to Claim 1 or 2, in which, in the optical sensor (50, 55), the partial influencing of the optical signal (S1) as a function of the interfering variable is brought about by a temperature (T) or a vibration (V).

4. Device for compensating for interfering variables in an optical sensor (50, 55),

   a) the optical sensor (50, 55) through which an optical signal (S1) passes being at least sensitive with respect to a measured variable (M), a wavelength (λ) of the optical signal (S1) and of an interfering variable (T, V), **characterized by**
   b) a compensation element (40, 45),

      c) into which the optical signal (S1) is to be fed and
      d) in which the wavelength (λ) of the optical signal (S1) is to be changed,

   wherein
   e) the compensation element (40, 45) together with the optical sensor (50, 55) is located in a common interfering variable effect region (60, 65) with largely equal effect of the interfering variable (T, V) on the optical sensor (50, 55) and on the compensation element (40, 45),
   f) the wavelength change (Δλ) can be influenced by the interfering variable (T, V),
   g) the optical signal (S1) with the change in wavelength (λ) influenced by the interfering variable (T, V) can be fed into the optical sensor (50, 55)
   and
   h) the partial influences which are exerted in the optical sensor (50, 55) on account of the change in wavelength (λ) influenced by the interfering variable (T, V) and on account of the interfering variable (T, V) can be at least largely compensated for in the optical sensor (50, 55).

5. Device according to Claim 4, in which the compensation element is designed as a Bragg grating (40, 45).

6. Device according to Claim 4 or 5, in which the compensation element (40, 45) is designed for an interfering variable present in the form of a temperature (T) or a vibration (V).

7. Device according to one of Claims 4 to 6, in which the compensation element (40, 45) comprises a housing (43, 44) and the configuration of the housing (43, 44) also contributes to the fact that the wavelength change (Δλ) under the influence of the interfering variable (T, V) takes place in a predetermined manner.

8. Device according to one of Claims 4 to 7, in which the compensation element (40, 45) comprises a coating (46).

**Revendications**

1. Procédé de compensation des grandeurs parasites d'un capteur (50, 55) optique, dans lequel

a) un signal (S1) lumineux dans le capteur (50, 55) optique est influencé au moins en fonction d'une grandeur (M) de mesure à détecter, d'une longueur d'onde (λ) du signal (S1) lumineux injecté et d'une grandeur (T, V) parasite,
**caractérisé en ce que**
b) le signal (S1) lumineux est injecté dans un élément (40, 45) de compensation, l'élément (40, 45) de compensation se trouvant, ensemble avec le capteur (50, 55) optique, dans une zone (60, 65) commune où des grandeurs parasites agissent, dans laquelle la grandeur (T, V) parasite a sensiblement le même effet sur le capteur (50, 55) optique et sur l'élément (40, 45) de compensation,
c) le signal (S1) lumineux subit une modification (Δλ) de longueur d'onde dans l'élément (40, 45) de compensation,
d) la variation (Δλ) de longueur d'onde dans l'élément (40, 45) de compensation est influencée par la grandeur (T, V) parasite,
e) le signal (S1) lumineux de longueur d'onde (λ) modifiée sous l'influence de la grandeur (T, V) parasite est injecté dans le capteur (50, 55) optique,
et
f) les influences partielles se produisant dans le capteur (50, 55) optique en raison de la longueur d'onde (λ) modifiée sous l'influence de la grandeur (T, V) parasite et en raison de la grandeur (T, V) parasite se suppriment mutuellement au moins en grande partie dans le capteur (50, 55) optique.

2. Procédé suivant la revendication 1, dans lequel la longueur d'onde du signal (S1) lumineux est modifiée dans un élément de compensation constitué sous la forme d'un réseau de Bragg (40, 45) .

3. Procédé suivant la revendication 1 ou 2, dans lequel l'influence partielle en fonction des grandeurs parasites sur le signal (S1) lumineux dans le capteur (50, 55) optique est provoquée par une température (T) ou par une vibration (V).

4. Dispositif de compensation des grandeurs parasites d'un capteur (50, 55) optique, dans lequel

a) le capteur (50, 55) optique parcouru par un signal (S1) lumineux est au moins sensible à une grandeur (M) de mesure, à une longueur d'onde (λ) du signal (S1) lumineux et à une grandeur (T, V) parasite,
**caractérisé par**
b) un élément (40, 45) de compensation,
c) dans lequel le signal (S1) lumineux est injecté,
et
d) dans lequel la longueur d'onde (λ) du signal (S1) lumineux peut être modifiée,
dans lequel
e) l'élément (40, 45) de compensation se trouve, ensemble avec le capteur (50, 55) optique, dans une zone (60, 65) commune où des grandeurs parasites agissent, dans laquelle la grandeur (T, V) parasite a, dans une grande mesure, le même effet sur le capteur (50, 55) optique et sur l'élément (40, 45) de compensation,
f) la variation (Δλ) de longueur d'onde peut être influencée par la grandeur (T, V) parasite,
g) le signal (S1) lumineux de longueur d'onde (λ) modifiée sous l'influence de la grandeur (T, V) parasite peut être injecté dans le capteur (50, 55) optique,
et
h) les influences partielles se produisant dans le capteur (50, 55) optique en raison de la longueur d'onde (λ) modifiée sous l'influence de la grandeur (T, V) parasite et en raison de la grandeur (T, V) parasite peuvent être compensées mutuellement au moins en grande partie dans le capteur (50, 55) optique.

**5.** Dispositif suivant la revendication 4, dans lequel l'élément de compensation est constitué sous la forme d'un réseau de Bragg (40, 45).

**6.** Dispositif suivant la revendication 4 ou 5, dans lequel l'élément (40, 45) de compensation est conçu pour une grandeur parasite se présentant sous la forme d'une température (T) ou d'une vibration (V).

**7.** Dispositif suivant l'une des revendications 4 à 6, dans lequel l'élément (40, 45) de compensation comprend un boîtier (43, 44) et la conformation du boîtier (43, 44) contribue à ce que la modification ($\Delta\lambda$) de longueur d'onde s'effectue d'une façon déterminée à l'avance sous l'influence de la grandeur (T, V) parasite.

**8.** Dispositif suivant l'une des revendications 4 à 7, dans lequel l'élément (40, 45) de compensation comprend un revêtement (46).

**FIG 1**

**FIG 2**

**FIG 3**

**FIG 4**